# EUROPEAN PATENT APPLICATION

(11) **EP 4 823 046 A2**
(43) Date of publication of application: **14.10.2026**
(21) Application number: 26160650.3
(22) Date of filing: 25.02.2026
(51) Int. Cl.: H04L 25/02, G05B 19/042, G08C 19/02

(54) **ISOLATED ANALOG SENSOR CIRCUIT**

(30) Priority: 09.04.2025 US 202519174097
(71) Applicant: Analog Devices, Inc., Wilmington, MA 01887 (US)
(72) Inventor: HEMATY, Arman, Wilmington, 01887 (US); KURTSEVOY, Yuriy, Wilmington, 01887 (US); HELFRICH, Kenneth J., Wilmington, 01887 (US)
(74) Representative: Yang, Shu

(57) **Abstract**

A circuit for bi-directional communication between a master device and an isolated sensor. The circuit comprising a master-side conversion circuit operating at a master ground reference of the master device, the master-side conversion circuit configured to convert communications output from and input to the master device, a sensor-side conversion circuit operating at a sensor ground reference of the isolated sensor, the sensor-side conversion circuit configured to convert communications output from and input to the isolated sensor, and an isolation circuit positioned between the master-side conversion circuit and the sensor-side conversion circuit, the isolation circuit configured to power the isolated sensor by isolating the master ground reference from the isolated sensor ground reference during power transfer and data transfers between the master device and the isolated sensor.

## Description

This application claims priority to U.S. non-provisional application number 19/174,097, filed on 9 April 2025.

### FIELD

The present disclosure generally relates to an isolation circuit for supporting isolated loop power and communication between a sensor and master device.

### BACKGROUND

Industrial process control and automation systems often utilize sensors to monitor and control various parameters in manufacturing, chemical processing, and other industrial applications. These sensors typically communicate with master control systems using standardized protocols, such as the Highway Addressable Remote Transducer (HART) protocol. HART allows digital communication to be superimposed on traditional 4-20mA analog current signals, enabling bidirectional data exchange between smart field instruments and control systems. This dual-mode communication provides the ability to transmit primary measured values as analog signals while simultaneously sending additional information such as device status, calibration data, and diagnostic alerts digitally.

However, implementing such communication in isolated sensor environments presents several challenges. Electrical isolation between sensors and control systems is often important for safety and signal integrity, but this isolation can complicate power distribution and data communication. Additionally, many industrial sensors operate under strict power constraints, typically limited to loop-powered systems drawing less than 3.5mA. This power limitation makes it difficult to achieve high measurement accuracy while maintaining robust communication capabilities. Furthermore, the physical size constraints of sensor housings can restrict the implementation of complex isolation and communication circuitry, potentially compromising performance or functionality.

Conventional approaches to addressing isolation challenges in sensor communication systems often place the burden of isolation on the master device. This approach may be problematic due to the wide variety of sensors that operate at different ground references. In some cases, the master device may need to accommodate multiple isolation schemes and voltage conversions to interface with different types of sensors, potentially leading to increased complexity, cost, and power consumption in the master device.

### SUMMARY

This summary is provided to introduce a selection of concepts in a simplified form that are further described below in the detailed description. This summary is not intended to identify essential features of the claimed subject matter, nor is it intended to be used as an aid in determining the scope of the claimed subject matter.

In one aspect, the present disclosure relates to a circuit for bi-directional communication between a master device and an isolated sensor, comprising a master-side conversion circuit operating at a master ground reference of the master device, the master-side conversion circuit configured to convert communications output from and input to the master device, a sensor-side conversion circuit operating at a sensor ground reference of the isolated sensor, the sensor-side conversion circuit configured to convert communications output from and input to the isolated sensor, and an isolation circuit positioned between the master-side conversion circuit and the sensor-side conversion circuit, the isolation circuit configured to power the isolated sensor by isolating the master ground reference from the isolated sensor ground reference during power transfer and data transfers between the master device and the isolated sensor.

In embodiments of this aspect, the disclosure according to any one of the above example embodiments, wherein the isolation circuit comprises a transformer configured to convert a master voltage of the master device to a sensor voltage of the isolated sensor and isolate the master ground reference from the sensor ground reference, and isolation barriers configured to transmit signals between the master-side conversion circuit and the sensor-side conversion circuit.

In embodiments of this aspect, the disclosure according to any one of the above example embodiments, wherein the isolation barriers comprise a first isolation barrier for transmitting signals from the master-side conversion circuit to the sensor-side conversion circuit, and a second isolation barrier for transmitting signals from the sensor-side conversion circuit to the master-side conversion circuit.

In embodiments of this aspect, the disclosure according to any one of the above example embodiments, wherein the master-side conversion circuit comprises a master analog-to-digital converter configured to convert master analog signals from the master device to master digital signals for transmission through the isolation circuit to the sensor-side conversion circuit, and a master digital-to-analog converter configured to convert sensor digital signals received through the isolation circuit from the isolated sensor to sensor analog signals for transmission to the master device, and wherein the sensor-side conversion circuit comprises a sensor analog-to-digital converter configured to convert sensor analog signals from the isolated sensor to sensor digital signals for transmission through the isolation circuit to the master-side conversion circuit, and a sensor digital-to-analog converter configured to convert the master digital signals received through the isolation circuit from the master device to the master analog signals for transmission to the isolated sensor.

In embodiments of this aspect, the disclosure according to any one of the above example embodiments, wherein the master device is configured to modulate data on a DC master signal transmitted on master current line to the master-side conversion circuit, the data comprising a request for the isolated sensor, and wherein the isolated sensor is configured to modulate the data on a DC sensor signal transmitted on a sensor current line to the sensor-side conversion circuit, the data comprising a response to the request.

In embodiments of this aspect, the disclosure according to any one of the above example embodiments, wherein the master-side conversion circuit operates at a first voltage level and with reference to the master ground reference, wherein the sensor-side conversion circuit operates at a second voltage level and with reference to the sensor ground reference, and wherein the circuit electrically isolates the first voltage level and the master ground reference from the second voltage level and the sensor ground reference.

In embodiments of this aspect, the disclosure according to any one of the above example embodiments, wherein the isolation circuit comprises a transformer configured to convert the first voltage level to the second voltage level while maintaining electrical isolation between the master ground reference and the sensor ground reference.

In one aspect, the present disclosure relates to a method for bi-directional communication between a master device and an isolated sensor, comprising converting, by a master-side conversion circuit operating at a master ground reference of the master device, communications output from and input to the master device, converting, by a sensor-side conversion circuit operating at a sensor ground reference of the isolated sensor, communications output from and input to the isolated sensor, and powering the isolated sensor and isolating data transfers between the master device and the isolated sensor using an isolation circuit positioned between the master-side conversion circuit and the sensor-side conversion circuit, wherein powering the isolated sensor comprises converting the voltage of the master device to the voltage of the isolated sensor and isolating the master ground reference from the sensor ground reference.

In embodiments of this aspect, the disclosure according to any one of the above example embodiments, comprising converting, by a transformer, the master voltage of the master device to the sensor voltage of the isolated sensor, and processing, by isolation barriers, signals transmitted between the master-side conversion circuit and the sensor-side conversion circuit to isolate the master ground reference from the sensor ground reference during data transfers.

In embodiments of this aspect, the disclosure according to any one of the above example embodiments, comprising transmitting signals from the master-side conversion circuit to the sensor-side conversion circuit using a first isolation barrier, and transmitting signals from the sensor-side conversion circuit to the master-side conversion circuit using a second isolation barrier.

In embodiments of this aspect, the disclosure according to any one of the above example embodiments, comprising converting communications by the master-side conversion circuit by converting master analog signals from the master device to master digital signals for transmission through the isolation circuit to the sensor-side conversion circuit using a master analog-to-digital converter, and converting sensor digital signals received through the isolation circuit from the isolated sensor to sensor analog signals for transmission to the master device using a master digital-to-analog converter, and converting communications by the sensor-side conversion circuit by converting sensor analog signals from the isolated sensor to sensor digital signals for transmission through the isolation circuit to the master-side conversion circuit using a sensor analog-to-digital converter, and converting the master digital signals received through the isolation circuit from the master device to the master analog signals for transmission to the isolated sensor using a sensor digital-to-analog converter.

In embodiments of this aspect, the disclosure according to any one of the above example embodiments, further comprising modulating, by the master device, data on a DC master signal transmitted on a master current line to the master-side conversion circuit, the data comprising a request for the isolated sensor, and modulating, by the isolated sensor, the data on a DC sensor signal transmitted on a sensor current line to the sensor-side conversion circuit, the data comprising a response to the request.

In embodiments of this aspect, the disclosure according to any one of the above example embodiments, comprising operating the master-side conversion circuit at a first voltage level and with reference to the master ground reference, operating the sensor-side conversion circuit at a second voltage level and with reference to the sensor ground reference, and electrically isolating the first voltage level and the master ground reference from the second voltage level and the sensor ground reference.

In embodiments of this aspect, the disclosure according to any one of the above example embodiments, wherein the isolation circuit comprises a transformer, and the method further comprises converting, by the transformer of the isolation circuit, the first voltage level to the second voltage level while maintaining electrical isolation between the master ground reference and the sensor ground reference.

In one aspect, the present disclosure relates to a system for bi-directional communication, comprising a master device, an isolated sensor, and a circuit comprising a master-side conversion circuit operating at a master ground reference of the master device, the master-side conversion circuit configured to convert communications output from and input to the master device, a sensor-side conversion circuit operating at a sensor ground reference of the isolated sensor, the sensor-side conversion circuit configured to convert communications output from and input to the isolated sensor, and an isolation circuit positioned between the master-side conversion circuit and the sensor-side conversion circuit, the isolation circuit configured to power the isolated sensor by isolating the master ground reference from the sensor ground reference during power transfer and data transfers between the master device and the isolated sensor.

In embodiments of this aspect, the disclosure according to any one of the above example embodiments, wherein the isolation circuit comprises a transformer configured to convert the master voltage of the master device to the sensor voltage of the isolated sensor, and isolation barriers configured to transmit signals between the master-side conversion circuit and the sensor-side conversion circuit.

In embodiments of this aspect, the disclosure according to any one of the above example embodiments, wherein the isolation barriers comprise a first isolation barrier transmitting signals from the master-side conversion circuit to the sensor-side conversion circuit, and a second isolation barrier transmitting signals from the sensor-side conversion circuit to the master-side conversion circuit.

In embodiments of this aspect, the disclosure according to any one of the above example embodiments, wherein the master-side conversion circuit comprises a master analog-to-digital converter configured to convert master analog signals from the master device to master digital signals for transmission through the isolation circuit to the sensor-side conversion circuit, and a master digital-to-analog converter configured to convert sensor digital signals received through the isolation circuit from the isolated sensor to sensor analog signals for transmission to the master device, and wherein the sensor-side conversion circuit comprises a sensor analog-to-digital converter configured to convert sensor analog signals from the isolated sensor to sensor digital signals for transmission through the isolation circuit to the master-side conversion circuit, and a sensor digital-to-analog converter configured to convert master digital signals received through the isolation circuit from the master device to master analog signals for transmission to the isolated sensor.

In embodiments of this aspect, the disclosure according to any one of the above example embodiments, wherein the master device is configured to modulate data on a DC master signal transmitted on a master current line to the master-side conversion circuit, the data comprising a request for the isolated sensor, and wherein the isolated sensor is configured to modulate the data on a DC sensor signal transmitted on a sensor current line to the sensor-side conversion circuit, the data comprising a response to the request.

In embodiments of this aspect, the disclosure according to any one of the above example embodiments, wherein the master-side conversion circuit operates at a first voltage level and with reference to the master ground reference, wherein the sensor-side conversion circuit operates at a second voltage level and with reference to the sensor ground reference, and wherein the circuit electrically isolates the first voltage level and the master ground reference from the second voltage level and the sensor ground reference.

The foregoing general description of the illustrative embodiments and the following detailed description thereof are merely exemplary aspects of the teachings of this disclosure and are not restrictive.

### BRIEF DESCRIPTION OF THE DRAWINGS

So that the way the above-recited features of the present disclosure can be understood in detail, a more particular description of the disclosure, briefly summarized above, may be made by reference to example embodiments, some of which are illustrated in the appended drawings. It is to be noted, however, that the appended drawings illustrate only example embodiments of this disclosure and are therefore not to be considered limiting of its scope, for the disclosure may admit to other equally effective example embodiments.
FIG. 1 illustrates a sensor system with a master controller and multiple sensor assemblies, according to aspects of the present disclosure.
FIG. 2 illustrates a sensor system include a sensor device, master device, and circuit, according to aspects of the present disclosure.
FIG. 3A illustrates a flowchart of a method for communication between a master and a sensor via the circuit, according to aspects of the present disclosure.
FIG. 3B illustrates another flowchart of a method for communication between a master and a sensor via the circuit, according to aspects of the present disclosure.

### DETAILED DESCRIPTION

The present disclosure relates to a communication-enabled isolated analog sensor transmitter system that may enable bi-directional communication between a master device and an isolated sensor. The system may include a master device, an isolated sensor, and a circuit configured to facilitate communication between the master device and the isolated sensor while maintaining electrical isolation.

While the present disclosure may refer to the implementation of the highway addressable remote transducer (HART) protocol that modulates data on an analog current reading signal in the range of 4-20mA, the communication-enabled isolated analog sensor transmitter system may be applicable to any communication protocol that modulates data on an analog current signal. This flexibility allows the system to be adapted for use with various industrial communication standards that utilize similar principles of superimposing digital data on analog signals. The underlying architecture of the system, with its isolation circuit and conversion mechanisms, may be tailored to accommodate different modulation techniques, data rates, and signal characteristics associated with these various protocols, while maintaining the core benefits of electrical isolation, bi-directional communication, and efficient power management.

The circuit may include three main components: a master-side conversion circuit, a sensor-side conversion circuit, and a circuit positioned between the two conversion circuits. The master-side conversion circuit may operate at the ground reference (e.g. Earth ground) of the master device and may be configured to convert communications output from and input to the master device. Similarly, the sensor-side conversion circuit may operate at the ground reference (e.g., floating ground) of the isolated sensor and may be configured to convert communications output from and input to the isolated sensor.

The intermediary circuit between the sensor and master may serve two primary functions. First, it may loop power the isolated sensor by converting the voltage of the master device to the voltage of the isolated sensor while isolating the master ground reference from the sensor ground reference. Second, it may isolate data transfers between the master device and the isolated sensor, ensuring electrical separation between the two sides of the system while allowing for bi-directional communication. Isolation between the master device and sensors is beneficial because the master device may operate at Earth ground as its ground reference, while sensors often have floating grounds that may differ from one the master and from another. This ground potential difference can arise due to various factors in industrial environments, such as ground loops, or the presence of high-voltage equipment. Without proper isolation, these ground potential differences may lead to measurement errors, signal distortion, or even damage to sensitive electronic components. By implementing electrical ground isolation, the system may prevent unwanted current flow between different ground potentials, maintain signal integrity, and protect both the master device and sensors from potential ground-related issues. This isolation may allow sensors with different floating grounds to communicate reliably with the Earth-grounded master device, enabling the creation of more flexible and robust industrial control and monitoring systems, regardless of whether or not the master and sensors operate at the same or different voltage levels.

This configuration may allow for efficient and reliable communication between the master device and the isolated sensor while maintaining the electrical isolation. The system may be particularly useful in industrial applications where sensors need to operate in environments with different ground references than the master control devices.

The present disclosure provides several advantages over existing technologies in the field of isolated sensor communication. One significant benefit is the improved bi-directional communication capability between a master device and an isolated sensor. This enhanced communication allows for more efficient and reliable data exchange, enabling better monitoring and control in various industrial applications.

Another advantage of the disclosure is its compact design. The sensor system may fit within a small sensor housing, making it ideal for applications where space is at a premium. This compact form factor does not compromise functionality, as the system still maintains electrical isolation between the master device and the sensor while enabling bi-directional communication.

The disclosure's approach to signal isolation and conversion may offer improved noise immunity and signal integrity compared to traditional methods. By converting analog signals to digital form for transmission across the isolation barrier, and then back to analog, the system may reduce susceptibility to electromagnetic interference and other sources of signal degradation.

The flexibility of the disclosure allows for its application in a wide range of industrial settings. It may be particularly beneficial in process control, automation, and monitoring systems where accurate, reliable, and isolated sensor measurements are important.

By addressing the challenges of bi-directional communication, power consumption, and size constraints, the disclosure may enable the development of more advanced and efficient sensor networks in industrial environments. This may lead to improved process control, increased safety, and enhanced operational efficiency across various industries.

A communication-enabled isolated analog sensor transmitter system may find applications across various industrial sectors where precise process control and monitoring are beneficial. In chemical processing plants, for example, the system may be utilized to measure and control parameters such as temperature, pressure, and flow rates in reactor vessels. The ability to maintain electrical isolation while enabling bi-directional communication may enhance safety in potentially hazardous environments where flammable or corrosive chemicals are present.

In oil refineries, the system may be employed to monitor and control multiple stages of the refining process. The isolated sensors may be deployed in high-temperature or high-pressure environments, such as distillation columns or catalytic crackers, while maintaining reliable communication with centralized control systems. This may allow for real-time adjustments to process parameters, potentially improving efficiency and product quality.

Manufacturing facilities may benefit from the system's capability to integrate sensors operating at different ground references. For instance, in automotive manufacturing, sensors monitoring welding processes may require isolation from controllers controlling robotic assembly lines. The system may facilitate seamless integration of these diverse sensor networks into a unified control architecture.

In water treatment plants, the system may enable precise monitoring of water quality parameters throughout the treatment process. Isolated sensors measuring pH, turbidity, or chlorine levels may communicate reliably with central control systems, potentially enhancing the efficiency of treatment processes and ensuring compliance with regulatory standards.

The system may also find applications in pharmaceutical manufacturing, where maintaining sterile conditions is important. Isolated sensors may be used to monitor and control parameters in bioreactors or freeze-drying processes, potentially improving product consistency and quality while adhering to stringent regulatory requirements.

In the food and beverage industry, the system may be utilized for process control in areas where electrical isolation is important due to the presence of conductive liquids or the need for frequent washdowns. For example, in dairy processing, isolated sensors may monitor pasteurization temperatures or flow rates while maintaining hygienic conditions.

These diverse applications highlight the potential versatility of the communication-enabled isolated analog sensor transmitter system across various industrial settings. The system's ability to facilitate bi-directional communication while maintaining electrical isolation may contribute to improved process control, enhanced safety, and increased operational efficiency in numerous industrial applications.

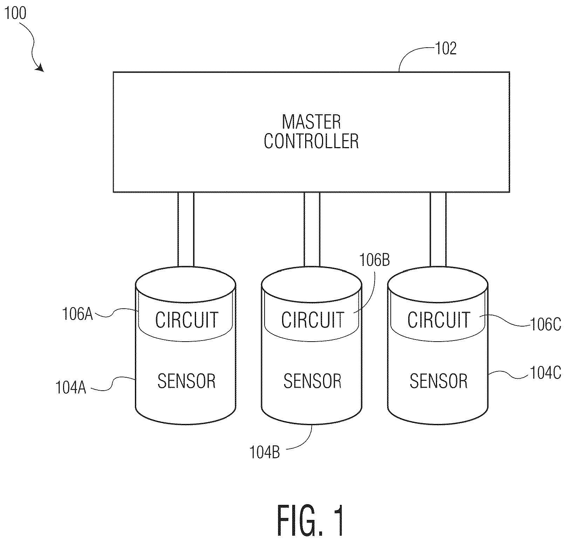

FIG. 1 illustrates a sensor system 100 that may include a master controller 102 (e.g., programmable logic controller (PLC), distributed control system (DCS), industrial computer, Supervisory Control and Data Acquisition (SCADA) systems, etc.) connected to multiple sensor assemblies. The sensor system 100 may include a first sensor 104A, a second sensor 104B, and a third sensor 104C, each having an associated circuit - a first circuit 106A, a second circuit 106B, and a third circuit 106C, respectively. While FIG. 1 depicts three sensors for illustrative purposes, the sensor system 100 may accommodate any number of sensors connected to the master controller 102. In industrial installations, the master controller 102 may interface with numerous sensors (e.g., hundreds or even thousands, depending on the scale and complexity of the monitored process or facility). This scalability allows the system to be adapted to various application requirements, from small-scale operations to large, complex industrial environments. Electrical isolation of the master ground to the individual sensor grounds is beneficial for proper operation.

In some cases, the circuits 106A, 106B, and 106C may be integrated into the respective sensors to ensure electrical isolation with the master controller 102 while still allowing communication. This integration may enable each sensor assembly to operate independently while maintaining a connection to the central master controller 102.

The master controller 102 may be positioned at the top of the diagram and may connect individually to each of the three circuit and sensor combinations below it. Each connection may include two lines between the master controller 102 and the respective circuits 106A, 106B, and 106C. These connections may enable bidirectional communication and power distribution throughout the sensor system 100.

In some cases, the sensor system 100 may demonstrate a distributed architecture where each sensor 104A, 104B, and 104C may operate independently with its own dedicated circuit 106A, 106B, and 106C while maintaining communication with the central master controller 102. This architecture may allow for flexible deployment of sensors in various configurations while centralizing control and data collection through the master controller 102.

The sensor system 100 may be adaptable to various applications. For example, in an industrial setting, the first sensor 104A may be a temperature sensor, the second sensor 104B may be a pressure sensor, and the third sensor 104C may be a flow rate sensor. Each sensor may communicate its readings through its respective circuit to the master controller 102, which may then process and act upon the collected data.

In some aspects, integrating the circuit into the sensor may allow sensor manufacturers to produce sensors with built-in capabilities for safe and effective isolation between the sensor and master device. This integration may enable loop powering from the master while facilitating isolated bidirectional communication. By incorporating the circuitry directly into the sensor housing, manufacturers may create self-contained units that can seamlessly interface with master devices operating at different ground references. This approach may simplify installation and maintenance processes, as the integrated sensors may be readily deployed in various industrial environments without the need for additional external isolation components. The built-in circuitry may handle voltage conversion, ground isolation, signal isolation, and communication protocol management, potentially reducing system complexity and improving overall reliability. This integration may also contribute to the compact design of the sensor system, making it suitable for applications where space is limited while maintaining the benefits of electrical isolation and robust communication capabilities.

The subsequent figures provide a detailed illustration and explanation of the electrical and functional aspects of the circuit within the sensor system. These figures depict the various components and connections that enable the system's operation, including the master-side conversion circuit, sensor-side conversion circuit, and isolation circuit. The diagrams may showcase how these elements interact to facilitate power conversion, signal processing, and bi-directional communication while maintaining electrical isolation for both power transfer and data transfer between the master and sensors. Additionally, the figures demonstrate the flow of data and power through the system, highlighting conversion and isolation points. By presenting these technical details, the figures may offer a comprehensive view of the circuit's architecture and functionality, allowing for a deeper understanding of the innovative aspects of the communication-enabled (e.g. HART enabled) isolated analog sensor transmitter system.

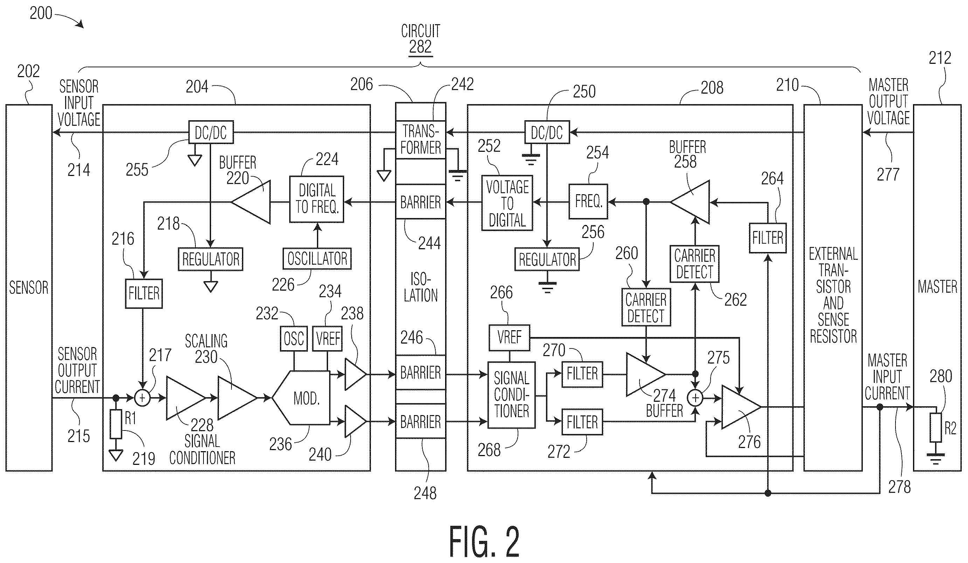

FIG. 2 illustrates a sensor system 200 including a sensor device 202 operating at a floating ground reference, a master device 212 operating at Earth ground reference, and a circuit 282 including a sensor-side conversion circuit 204 operating at the floating ground reference of the sensor device, an isolation circuit 206 operating at both the floating ground reference of the sensor device and the Earth ground reference of the master device, a master-side conversion circuit 208 operating at the Earth ground reference of the master device, and an external transistor and sense resistor 210.

While the circuit 282 is depicted as a separate component from the sensor device 202 in FIG. 2 for clarity of illustration, it is noted that in one example, circuit 282 is integrated into the front end of the sensor device 202 as shown in FIG. 1. This integration may allow for a more compact and efficient design, where the sensor-side conversion circuit 204, isolation circuit 206, and master-side conversion circuit 208 are incorporated directly into the sensor housing. By integrating these components, the sensor device 202 may become a self-contained unit that includes both the sensing elements and the circuitry for power conversion, signal processing, and communication. This integrated approach may offer advantages in terms of reduced size, improved reliability, and simplified installation, as the system - including the isolation and communication capabilities - may be contained within a single sensor package.

The sensor-side conversion circuit 204, isolation circuit 206, and master-side conversion circuit 208 may work together to facilitate loop power and bidirectional communication between the sensor device 202 and the master device 212. The sensor-side conversion circuit 204 may handle signal processing and conversion on the sensor side, adapting sensor signals for transmission and interpreting received signals. The isolation circuit 206 may provide electrical isolation between the sensor and master sides, allowing for safe power transfer and signal transmission between devices operating at different ground references. The master-side conversion circuit 208 may manage signal processing and conversion on the master side, preparing signals for transmission to the sensor and interpreting received sensor data. Together, these circuits may enable efficient power distribution from the master to the sensor through the loop while maintaining electrical isolation, and may facilitate bidirectional data exchange by converting and isolating signals as they pass between the sensor and master devices.

As shown in FIG. 2, the sensor-side conversion circuit 204 may operate at a sensor voltage (e.g. 24v) and ground reference (e.g., floating ground) of the sensor device 202 and may be configured to convert communications output from and input to the sensor device 202. The sensor-side conversion circuit 204 may include a data filter 216, a summing node 217, a voltage regulator 218, a sensor current line resistor 219, a buffer 220, a digital to frequency converter 224, an oscillator 226, a signal conditioner 228, a scaling component 230, an oscillator 232, a reference voltage (VREF) 234, a modulator 236, amplifiers 238 and 240, and DC/DC converter 255. Although not shown, regulator 218 is electrically connected to and powers the electrical devices in the sensor-side conversion circuit 204 with appropriate operating voltages which may be less than the sensor voltage.

The isolation circuit 206 may be positioned between the master-side conversion circuit 208 and the sensor-side conversion circuit 204. The isolation circuit 206 may be configured to power the sensor device 202 by converting the master voltage of the master device 212 to the sensor voltage (e.g. 24v) of the sensor device 202 thereby powering the sensor while isolating the ground reference (e.g., Earth ground) of the master device 212 from the ground reference (e.g., floating ground) of the sensor device 202 during both power and data transfer. Specifically, isolation circuit 206 may include an isolation transformer 242 to perform the voltage conversion with primary and secondary windings operating at the ground reference (e.g., Earth ground) of the master device 212 and the ground reference (e.g., floating ground) of the sensor device 202 respectively. It is noted that the master voltage and sensor voltage may be the same voltage or different voltages as long as isolation transformer 242 provides isolation between the master ground reference and sensor ground reference. The isolation circuit 206 may also include isolation barriers 244, 246, and 248 configured to transfer data signals (sensor readings, data, etc.) between the master-side conversion circuit 208 and the sensor-side conversion circuit 204 in a manner that ensures isolation between the master ground reference and the sensor ground reference.

More specifically, isolation barriers 244, 246, and 248 transfer data between the isolated circuits without establishing a direct electrical connection to ensure ground reference isolation. These components may utilize various isolation technologies to maintain electrical separation while allowing signal transmission. In some implementations, optical isolation techniques may be employed, where electrical signals are converted to light pulses and back, ensuring complete galvanic isolation. Alternatively, electromagnetic (EM) isolation methods may be used, leveraging inductive or capacitive coupling to transfer signals across the isolation barrier. Other potential isolation mechanisms may include magnetoresistive, piezoelectric, or radio frequency (RF) based approaches to name a few.

The master-side conversion circuit 208 may operate at a ground reference (e.g., Earth ground) of the master device 212 and may be configured to convert communications output from and input to the master device 212. The master-side conversion circuit 208 may include a DC/DC converter 250, a voltage to digital converter 252, a frequency to voltage converter 254, a regulator 256, buffers 258 and 274, carrier detectors 260 and 262, data filters 264 and 270, a VREF 266, a signal conditioner 268, a low pass filter 272, a summing node 275, and an amplifier 276. Although not shown, regulator 256 is electrically connected to and powers the electrical devices in the master-side conversion circuit 208 with appropriate operating voltages which may be less than the master voltage.

Now that the components of the sensor system 200 have been introduced, the functionality of the system in FIG. 2 may be described in detail. This detailed explanation may elucidate the processes involved in power transfer, signal conversion, and bidirectional communication between the master device 212 and the sensor device 202. The description may cover the flow of power from the master device to the sensor device, the conversion of analog signals to digital data and vice versa, the isolation of signals for electrical safety, and the modulation and demodulation of data on the current loop. By examining these processes, a comprehensive understanding of how the sensor-side conversion circuit 204, isolation circuit 206, and master-side conversion circuit 208 work in concert to enable efficient, safe, and reliable communication and power distribution within the system may be gained.

In the sensor system 200, loop power may be provided from the master device 212 to the sensor device 202 via circuit 282 through a series of voltage conversions and isolations. The process may begin with the master device 212 sending a master output voltage on line 277 to the external transistor and sense resistor 210. This voltage may then pass to the DC/DC converter 250 within the master-side conversion circuit 208, which may adjust the voltage to a suitable level for transmission across the isolation barrier. The converted voltage may then be transferred to the isolation transformer 242 within the isolation circuit 206, which may provide electrical isolation between the master and sensor sides while stepping down the voltage to allow power transfer to the sensor. On the sensor side, the isolated voltage may be received on the sensor voltage line 214 which is passed through DC/DC converter 255 to power the sensor device 202, effectively converting the master voltage to the desired sensor voltage while maintaining electrical isolation (e.g. ground reference isolation) between the master device 212 and sensor device 202.

In some implementations, the master device 212 may provide power to the sensor device 202 in various modes to optimize energy efficiency and system performance. The master device 212 may supply power continuously, ensuring constant availability of the sensor for real-time monitoring and immediate response to queries. Alternatively, the master device 212 may power the sensor periodically, activating it at predetermined intervals to conserve energy while still maintaining regular data collection. In some cases, the power supply may be event-driven, where the master device 212 energizes the sensor device 202 in response to specific triggers or conditions, such as external stimuli, threshold crossings, or on-demand requests from the control system. This flexible approach to power management may allow the sensor system 200 to adapt to different application requirements, balancing power consumption with data acquisition needs and responsiveness.

In the sensor system 200, a command may be sent from the master device 212 to the sensor device 202 through a series of signal conversions and isolations. The master device 212 may initiate the process by modulating data on the current line 278, which represents the command to request a sensor reading and perform a specific action. This modulated signal may bypass the external transistor and sense resistor 210 before entering the master-side conversion circuit 208.

Within the master-side conversion circuit 208, the modulated analog signal may be processed through several stages. The data filter 264 may extract the command data from the current signal, which may then be buffered by buffer 258. The frequency to voltage converter 254 and voltage to digital converter 252 may transform the analog command signal into a digital format suitable for isolation. This digital representation of the command may then pass through the isolation circuit 206, specifically through the isolation barrier 244, which may maintain electrical isolation while facilitating data transfer. On the sensor side, the isolated digital command may be converted back to an analog signal by the digital to frequency converter 224 and buffered by buffer 220. The data filter 216 may then extract the command data, which may be combined with the analog current signal at the summing node 217. This reconstructed analog command signal may then be input to the sensor device 202 via the sensor current line 215. The sensor device 202 may interpret this modulated signal, perform the requested action, take a sensor reading, and prepare a response that includes both the requested data and the sensor reading.

In response to the command from the master device 212, the sensor device 202 may generate a response that includes both the requested data. This response may be modulated onto the analog current signal (i.e. the sensor reading) on the sensor current line 215. The modulated response signal may then pass through the summing node 217 and into the signal conditioner 228 within the sensor-side conversion circuit 204. The signal conditioner 228 may prepare the signal for transmission across the isolation barrier by applying appropriate scaling and conditioning.

The scaled and conditioned signal may then be input to the modulator 236, which may be driven by the oscillator 232 and VREF 234. The modulator 236 may convert the analog response signal into a digital format, creating a digital signal that represents both the sensor reading and the response data combined. The modulator 236 may be implemented as a sigma-delta modulator, which may provide high-resolution analog-to-digital conversion suitable for the sensor application. This type of modulator may offer advantages such as noise shaping and oversampling, potentially improving the signal-to-noise ratio and allowing for precise digitization of the analog response signal from the sensor device 202.

The modulator 236 may output a single digital signal that represents both the sensor reading and the response data combined, or output two separate digital signals by breaking up the digital signal into smaller digital signals to optimize bandwidth utilization and signal processing efficiency. For example, if the combined signal that represents both the sensor reading and the response data is a N-bits, then the N-bit data signal can be broken up into two N/2-bit signals as shown in FIG. 2. The choice between dual or single output may depend on factors such as the desired data resolution, system bandwidth constraints, and the specific requirements of the isolation and master-side circuits. In cases where bandwidth is less constrained or where simplified signal routing is preferred, a single output from the modulator 236 may be employed without significantly impacting the system's functionality.

These digital signals may then pass through amplifiers 238 and 240 before entering the isolation circuit 206. The isolation barriers 246 and 248 may maintain electrical isolation while facilitating data transfer of the digital signals to the master-side conversion circuit 208. On the master side, the signal conditioner 268, data filter 270, and low pass filter 272 may work together to convert the isolated digital signals back into analog form. The signal conditioner 268 may receive the isolated digital signals and recombine them into the N-bit signal which is then converted into an analog signal and sent to data filters 270 and 272. The data filter 270 may extract the data as an analog signal, while the low pass filter 272 may extract the sensor reading as an analog signal.

The analog response signals may be combined at the summing node 275, amplified by amplifier 276, and sent back to the master device 212 via the external transistor and sense resistor 210 and the master current line 278. The master device 212 may then convert the current signal to a voltage signal via resistor 280 in order to extract and interpret the sensor reading and response data.

Upon receiving and interpreting the sensor reading and response data, the master device 212 may perform various actions based on the information obtained. These actions may include adjusting process parameters, triggering alarms, logging data for trend analysis, or initiating additional queries to other sensors or devices in the system. In some cases, the master device 212 may compare the received sensor data against predefined thresholds or historical values to make decisions about system operation or maintenance requirements. The master device 212 may also use the response data to verify the successful execution of its previous command, update its internal status information about the sensor device 202, or initiate further communication if additional information or actions are desired. Depending on the application, the master device 212 may integrate the received data with information from other sources to perform complex control algorithms, optimize system performance, or generate reports for operators or other higher-level systems.

In the sensor system 200, the communication of data between the master device 212 and the sensor device 202 may be protected from unwanted echoes through the operation of buffers 258 and 274, in conjunction with carrier detectors 260 and 262. This echo suppression mechanism may help maintain the integrity of the bidirectional communication by preventing transmitted signals from looping back to their source.

During data transmission from the master device 212 to the sensor device 202, the carrier detector 260 may detect the presence of the master data transmission on the master current line 278. The carrier detector 260 may accomplish this by monitoring the signal amplitude or frequency characteristics on the output of buffer 258. Upon detecting this carrier signal, the carrier detector 260 may disable buffer 274. By disabling buffer 274, the system may prevent the master's own transmission from being echoed back through amplifier 276, effectively blocking any potential feedback loop that could interfere with the outgoing signal. When the carrier detector 260 no longer detects the master data transmission, it may re-enable buffer 274, allowing normal operation to resume.

Similarly, when the sensor device 202 is transmitting data to the master device 212, the carrier detector 262 may detect the presence of the sensor data transmission. The carrier detector 262 may utilize similar techniques as carrier detector 260, such as monitoring signal characteristics on the relevant signal path output by buffer 274. In response to this detection, the carrier detector 262 may disable buffer 258. This action may prevent the sensor's transmission from being echoed back through master current line 278, thereby avoiding any potential interference with the sensor's outgoing signal. Once the carrier detector 262 determines that the sensor data transmission has ended, it may re-enable buffer 258 to restore normal signal flow.

It is noted that the sensor device 202 and master device 212, while not explicitly shown in the diagram, may incorporate internal circuitry and processors to perform various functions beneficial to their operation within the sensor system 200. These internal components may include microcontrollers, digital signal processors, or application-specific integrated circuits (ASICs) that enable the devices to execute complex tasks. In the sensor device 202, such circuitry may be responsible for controlling the sensing elements, processing raw sensor data, and modulating the response data onto the analog current signal. Similarly, the master device 212 may contain sophisticated processing units capable of interpreting the received sensor data, executing control algorithms, and generating appropriate commands. These internal components may also handle tasks such as data encryption, error correction, and protocol management for the communication between the devices. The presence of these processing capabilities within both the sensor device 202 and master device 212 may allow for intelligent decision-making at both ends of the communication link, potentially enhancing the overall functionality and flexibility of the sensor system 200.

The intricate processes of power transfer, signal conversion, and bidirectional communication between the master device and the sensor device, as described above, may be further elucidated through the use of flowcharts. These flowcharts may provide a visual representation of the sequential steps involved in the operation of the sensor system 200, offering a clear and concise overview of the complex interactions between various components.

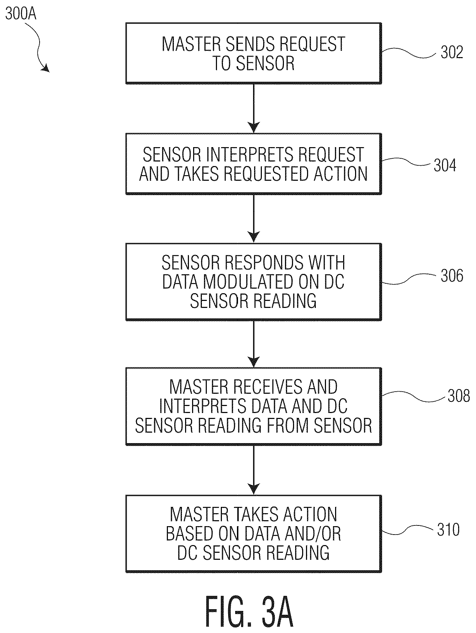

FIG. 3A illustrates a flowchart of a method 300A for communication between a master and a sensor, providing a visual representation of the steps involved in the process. The method 300A may include five steps: step 302 where the master sends a request to the sensor, step 304 where the sensor interprets the request and takes the requested action, step 306 where the sensor responds with data modulated on DC sensor reading, step 308 where the master receives and interprets the data and DC sensor reading from the sensor, and step 310 where the master takes action based on the data and/or DC sensor reading.

Step 302 of method 300A may involve the master device initiating communication by sending a request to the sensor. This request may be in the form of a command or query, which may be modulated onto the current loop connecting the master and sensor. The master device may use a specific protocol, such as HART, to encode the request, ensuring it can be properly interpreted by the sensor. This step may set the stage for the subsequent interaction between the master and sensor, defining the nature of the information or action of the sensor. In step 302, when the master device sends a request to the sensor, the carrier detector 260 may detect the master data transmission on the master current line 278 and disable buffer 274. This action may prevent the master's own transmission from being echoed back through amplifier 276, effectively blocking any potential feedback loop that could interfere with the outgoing signal.

Step 304 may encompass the sensor's processing of the received request. Upon receiving the modulated signal, the sensor may demodulate and decode the request to understand the master's instructions. The sensor may then interpret the request, which may involve parsing command parameters or identifying the specific data being requested. Based on this interpretation, the sensor may take the requested action, which may include taking a measurement, adjusting its configuration, or retrieving stored data. This step may be beneficial in ensuring that the sensor responds appropriately to the master's request.

In step 306, the sensor may formulate and transmit its response to the master's request. This response may include the data requested by the master, such as a sensor reading or status information. The sensor may modulate this data onto the DC sensor reading, which may be represented by the current in the loop. By modulating the response data onto the analog current signal, the sensor may be able to transmit both the primary measured value and additional digital information simultaneously, maximizing the information transfer within the constraints of the current loop. In step 306, when the sensor device 202 is transmitting data to the master device 212, the carrier detector 262 may detect the presence of the sensor data transmission and disable buffer 258. This action may prevent the sensor's transmission from being echoed back through the master-side conversion circuit 208 and onto the master current line 278, thereby avoiding any potential interference with the sensor's outgoing signal.

Step 308 may involve the master device receiving and processing the sensor's response. The master may detect the modulated signal on the current loop and demodulate it to extract both the DC sensor reading and the additional modulated data. The master may then interpret this information, which may include converting the current values to meaningful measurement units, decoding status information, or processing any other data sent by the sensor. This step may be beneficial for the master to obtain the information it requested and understand the sensor's current state.

In the final step 310, the master device may take action based on the received and interpreted data from the sensor. These actions may vary depending on the application and the nature of the received information. The master may update its internal records, adjust process parameters based on the sensor reading, trigger alarms if thresholds are exceeded, log data for later analysis, or initiate further communication with the sensor or other devices in the system. This step may represent the culmination of the communication cycle, where the information obtained from the sensor is utilized to inform decisions or actions within the broader control or monitoring system.

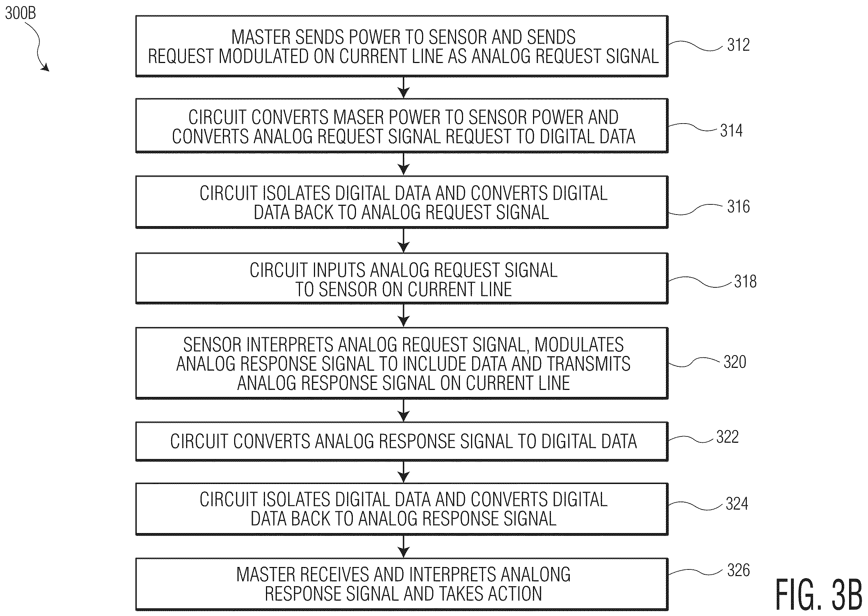

FIG. 3B illustrates a flowchart of a method 300B for communication between a master and a sensor using a current line, providing a more detailed representation of the signal conversion and isolation processes involved in the communication cycle. The method 300B may include eight steps: step 312 where the master sends power and a modulated request, step 314 where the circuit converts power and the analog request signal, step 316 where the circuit isolates and converts the digital data, step 318 where the circuit inputs the analog request signal to the sensor, step 320 where the sensor interprets the request and transmits a response, step 322 where the circuit converts the analog response to digital data, step 324 where the circuit isolates and converts the digital data back to an analog response signal, and step 326 where the master receives and interprets the response.

Step 312 of method 300B may involve the master device initiating communication by sending power and a modulated request to the sensor. The master may supply power to the sensor system through the current line, which may be a current loop. Simultaneously, the master may modulate a request signal onto this current line. This request may be in the form of a command or query, encoded using a specific protocol such as HART. The modulated signal may contain information about the desired action or data the master is requesting from the sensor. This step may set the foundation for the subsequent communication process, providing both the power and the initial instruction to the sensor system.

Step 314 may encompass the circuit's conversion of the power and analog request signal received from the master. In this step, the circuit may convert the master power to the appropriate voltage level while isolating the ground reference of the sensor. This conversion may involve stepping down the voltage or implementing other power conditioning techniques to ensure the sensor receives suitable power while isolating the master and ground reference from the sensor ground reference. Concurrently, the circuit may convert the analog request signal modulated on the current line into a digital format. This analog-to-digital conversion may prepare the request data for transmission across the isolation barrier, potentially improving signal integrity and noise immunity during the isolation process.

In step 316, the circuit may isolate and convert the digital data. The isolation process may involve transferring the digital data across the barrier, which may maintain separation between the master-side and sensor-side grounds. This isolation may be achieved through various methods such as optical, capacitive, or transformer-based isolation. After isolation, the circuit may convert the digital data back into an analog format suitable for input to the sensor. This digital-to-analog conversion may reconstruct the original request signal while maintaining the electrical isolation between the master and sensor sides of the system.

Step 318 may involve the circuit inputting the reconstructed analog request signal to the sensor. The circuit may modulate this analog signal onto the sensor-side current line, which may be operating at the sensor's voltage level and ground reference. This step may effectively deliver the master's request to the sensor in a format it can interpret, while maintaining the electrical isolation established in the previous steps. The sensor may then be ready to process the request and take appropriate action based on the received instruction. It is noted that while the master is transmitting the request signal in steps 312-318, carrier detector 260 may disable buffer 274 to ensure echoes do not return to the master.

In step 320, the sensor may interpret the analog request signal received from the circuit and formulate a response. The sensor may demodulate the signal from the current line, extract the request information, and perform the requested action. This action may include taking a measurement, adjusting settings, or retrieving stored data. After processing the request, the sensor may prepare a response that includes the requested data. The sensor may then modulate this response data onto the analog current signal on its current line, effectively combining the response data with the sensor reading.

Step 322 may encompass the circuit's conversion of the analog response signal from the sensor into digital data. The circuit may receive the modulated analog signal from the sensor's current line and perform an analog-to-digital conversion. The digitization process may prepare the sensor's response for transmission across the isolation barrier, potentially enhancing signal fidelity and allowing for more robust data handling in subsequent stages.

In step 324, the isolation process may transfer the digital data across the isolation barrier, maintaining separation between the sensor-side and master-side grounds. After isolation, the circuit may perform a digital-to-analog conversion, reconstructing the analog response signal which is a combination of the sensor reading and the response data, mirroring the original signal from the sensor but now referenced to the master-side ground.

Step 326 may involve the master receiving and interpreting the analog response signal from the circuit. The master may demodulate the signal received on its current line, extracting both the sensor reading and the response data. The master may then process this information, which may include converting the current values to meaningful measurement units, decoding status information, or analyzing any other data sent by the sensor. Based on this interpreted data, the master may take appropriate actions such as adjusting process parameters, logging data, or initiating further communication if necessary. This step may complete the communication cycle, allowing the master to utilize the sensor's information for system control or monitoring purposes.

The communication-enabled isolated analog sensor transmitter system may be adaptable to various industrial communication protocols that utilize current loop signaling, including but not limited to the HART protocol. While the system has been primarily described in the context of HART communication, which typically operates on a 4-20mA current loop, the underlying principles and architecture may be applicable to other protocols that modulate digital data onto analog current signals.

The flexibility of the system's design may allow it to accommodate different modulation techniques, data rates, and signal characteristics associated with various industrial communication standards. The core components of the system, including the isolation circuit, conversion mechanisms, and signal processing elements, may be tailored or reconfigured to support these different protocols while maintaining the benefits of electrical isolation, bi-directional communication, and efficient power management. This adaptability may enable the system to be deployed in diverse industrial environments, catering to specific communication requirements while preserving the advantages of the isolated sensor transmitter architecture.

In an industrial chemical processing plant, the HART-enabled isolated analog sensor transmitter system may be implemented to monitor and control a reactor vessel. The reactor may require temperature control and pressure monitoring to ensure beneficial reaction conditions and safety. In this scenario, a temperature sensor and a pressure sensor may be installed within the reactor, both utilizing the isolated analog sensor transmitter system to communicate with a central control system.

The temperature sensor may be configured to operate in a corrosive environment and at elevated temperatures, benefiting from electrical isolation from the control system. Similarly, the pressure sensor may be exposed to potentially explosive atmospheres, further highlighting the value of isolation.

During operation, the central control system may periodically poll the temperature and pressure sensors for readings. The master device may send a request to each sensor, modulating the command onto the current loop using the HART protocol. The isolated circuit may convert and isolate this request, allowing it to safely reach the sensors despite the different electrical environments. Upon receiving the request, each sensor may take a measurement and formulate a response, which may include not only the primary measured value (temperature or pressure) but also additional diagnostic information such as sensor health or calibration status.

The sensors may then transmit their responses back through the isolated circuit, which may convert the analog signals to digital form for isolation and then back to analog for the master device. The control system may interpret these responses and use the data to adjust reactor conditions. For instance, if the temperature sensor reports a value approaching an upper limit, the control system may activate cooling systems or reduce the reaction rate. Similarly, if the pressure sensor indicates a rapid pressure increase, the system may trigger venting procedures.

This use case demonstrates how the HART-enabled isolated analog sensor transmitter system may enable monitoring and control in a challenging industrial environment, maintaining safety and efficiency through electrical isolation and bidirectional communication capabilities. The system's ability to accommodate multiple sensors with different ground references while using the same master device highlights its flexibility and potential for widespread application in complex industrial settings.

While specific implementations have been described, variations and modifications may be possible within the scope of the invention. These may include adaptations for different types of sensors, alternative isolation techniques, or variations in the conversion processes. The system may be adaptable to evolving industrial needs and technological advancements, potentially extending its utility and longevity in the field of industrial automation and control.

While the foregoing is directed to example embodiments described herein, other and further example embodiments may be devised without departing from the basic scope thereof. For example, aspects of the present disclosure may be implemented in hardware or software or a combination of hardware and software. Portions of the disclosure described herein may be implemented as a program product for use with a computer system. The program(s) of the program product defines functions of the example embodiments (including the methods described herein) and may be contained on a variety of computer-readable storage media. Illustrative computer-readable storage media include, but are not limited to: (i) non-writable storage media (e.g., read-only memory (ROM) devices within a computer, such as CD-ROM disks readably by a CD-ROM drive, flash memory, ROM chips, or any type of solid-state non-volatile memory) on which information is permanently stored; and (ii) writable storage media (e.g., floppy disks within a diskette drive or hard-disk drive or any type of solid-state random-access memory) on which alterable information is stored. Such computer-readable storage media, when carrying computer-readable instructions that direct the functions of the presented example embodiments, are example embodiments of the present disclosure.

It will be appreciated by those skilled in the art that the preceding examples are exemplary and not limiting. It is intended that all permutations, enhancements, equivalents, and improvements thereto are apparent to those skilled in the art upon a reading of the specification and a study of the drawings are included within the true spirit and scope of the present disclosure. It is therefore intended that the following appended claims include all such modifications, permutations, and equivalents as fall within the true spirit and scope of these teachings.

### Numbered aspects

By way of non-limiting example, some aspects of the disclosure are set out in the following numbered clauses.
Numbered Clause 1. A circuit for bi-directional communication between a master device and an isolated sensor, comprising:
   a master-side conversion circuit operating at a master ground reference of the master device, the master-side conversion circuit configured to convert communications output from and input to the master device;
   a sensor-side conversion circuit operating at a sensor ground reference of the isolated sensor, the sensor-side conversion circuit configured to convert communications output from and input to the isolated sensor; and
   an isolation circuit positioned between the master-side conversion circuit and the sensor-side conversion circuit, the isolation circuit configured to power the isolated sensor by isolating the master ground reference from the isolated sensor ground reference during power transfer and data transfers between the master device and the isolated sensor.
Numbered Clause 2. The circuit of Numbered Clause 1,
   wherein the isolation circuit comprises:
   a transformer configured to convert a master voltage of the master device to a sensor voltage of the isolated sensor and isolate the master ground reference from the sensor ground reference; and
   isolation barriers configured to transmit signals between the master-side conversion circuit and the sensor-side conversion circuit.
Numbered Clause 3. The circuit of Numbered Clause 2,
   wherein the isolation barriers comprise:
   a first isolation barrier for transmitting signals from the master-side conversion circuit to the sensor-side conversion circuit; and
   a second isolation barrier for transmitting signals from the sensor-side conversion circuit to the master-side conversion circuit.
Numbered Clause 4. The circuit of any preceding Numbered Clause,
   wherein the master-side conversion circuit comprises:
   a master analog-to-digital converter configured to convert master analog signals from the master device to master digital signals for transmission through the isolation circuit to the sensor-side conversion circuit, and
   a master digital-to-analog converter configured to convert sensor digital signals received through the isolation circuit from the isolated sensor to sensor analog signals for transmission to the master device; and
   wherein the sensor-side conversion circuit comprises:
      a sensor analog-to-digital converter configured to convert sensor analog signals from the isolated sensor to sensor digital signals for transmission through the isolation circuit to the master-side conversion circuit, and
      a sensor digital-to-analog converter configured to convert the master digital signals received through the isolation circuit from the master device to the master analog signals for transmission to the isolated sensor.
Numbered Clause 5. The circuit of any preceding Numbered Clause,
   wherein the master device is configured to modulate data on a DC master signal transmitted on master current line to the master-side conversion circuit, the data comprising a request for the isolated sensor, and
   wherein the isolated sensor is configured to modulate the data on a DC sensor signal transmitted on a sensor current line to the sensor-side conversion circuit, the data comprising a response to the request.
Numbered Clause 6. The circuit of any preceding Numbered Clause,
   wherein the master-side conversion circuit operates at a first voltage level and with reference to the master ground reference,
   wherein the sensor-side conversion circuit operates at a second voltage level and with reference to the sensor ground reference, and
   wherein the circuit electrically isolates the first voltage level and the master ground reference from the second voltage level and the sensor ground reference.
Numbered Clause 7. The circuit of Numbered Clause 6,
   wherein the isolation circuit comprises a transformer configured to convert the first voltage level to the second voltage level while maintaining electrical isolation between the master ground reference and the sensor ground reference.
Numbered Clause 8. A method for bi-directional communication between a master device and an isolated sensor, comprising:
   converting, by a master-side conversion circuit operating at a master ground reference of the master device, communications output from and input to the master device;
   converting, by a sensor-side conversion circuit operating at a sensor ground reference of the isolated sensor, communications output from and input to the isolated sensor; and
   powering the isolated sensor and isolating data transfers between the master device and the isolated sensor using an isolation circuit positioned between the master-side conversion circuit and the sensor-side conversion circuit, wherein powering the isolated sensor comprises converting a master voltage of the master device to a sensor voltage of the isolated sensor and isolating the master ground reference from the sensor ground reference.
Numbered Clause 9. The method of Numbered Clause 8, comprising:
   converting, by a transformer, the master voltage of the master device to the sensor voltage of the isolated sensor; and
   processing, by isolation barriers, signals transmitted between the master-side conversion circuit and the sensor-side conversion circuit to isolate the master ground reference from the sensor ground reference during data transfers.
Numbered Clause 10. The method of Numbered Clause 9, comprising:
   transmitting signals from the master-side conversion circuit to the sensor-side conversion circuit using a first isolation barrier; and
   transmitting signals from the sensor-side conversion circuit to the master-side conversion circuit using a second isolation barrier.
Numbered Clause 11. The method of any of Numbered Clauses 8 to 10, comprising:
   converting communications by the master-side conversion circuit by:
   converting master analog signals from the master device to master digital signals for transmission through the isolation circuit to the sensor-side conversion circuit using a master analog-to-digital converter, and
   converting sensor digital signals received through the isolation circuit from the isolated sensor to sensor analog signals for transmission to the master device using a master digital-to-analog converter; and
   converting communications by the sensor-side conversion circuit by:
      converting sensor analog signals from the isolated sensor to sensor digital signals for transmission through the isolation circuit to the master-side conversion circuit using a sensor analog-to-digital converter, and
      converting the master digital signals received through the isolation circuit from the master device to the master analog signals for transmission to the isolated sensor using a sensor digital-to-analog converter.
Numbered Clause 12. The method of any of Numbered Clauses 8 to 11, further comprising:
   modulating, by the master device, data on a DC master signal transmitted on a master current line to the master-side conversion circuit, the data comprising a request for the isolated sensor; and
   modulating, by the isolated sensor, the data on a DC sensor signal transmitted on a sensor current line to the sensor-side conversion circuit, the data comprising a response to the request.
Numbered Clause 13. The method of any of Numbered Clauses 8 to 12, comprising:
   operating the master-side conversion circuit at a first voltage level and with reference to the master ground reference;
   operating the sensor-side conversion circuit at a second voltage level and with reference to the sensor ground reference; and
   electrically isolating the first voltage level and the master ground reference from the second voltage level and the sensor ground reference.
Numbered Clause 14. The method of Numbered Clause 13, wherein the isolation circuit comprises a transformer, and the method further comprises:
   converting, by the transformer of the isolation circuit, the first voltage level to the second voltage level while maintaining electrical isolation between the master ground reference and the sensor ground reference.
Numbered Clause 15. A system for bi-directional communication, comprising:
   a master device;
   an isolated sensor; and
   a circuit comprising:
      a master-side conversion circuit operating at a master ground reference of the master device, the master-side conversion circuit configured to convert communications output from and input to the master device,
      a sensor-side conversion circuit operating at a sensor ground reference of the isolated sensor, the sensor-side conversion circuit configured to convert communications output from and input to the isolated sensor, and
      an isolation circuit positioned between the master-side conversion circuit and the sensor-side conversion circuit, the isolation circuit configured to power the isolated sensor by isolating the master ground reference from the sensor ground reference during power transfer and data transfers between the master device and the isolated sensor.
Numbered Clause 16. The system of Numbered Clause 15,
   wherein the isolation circuit comprises:
   a transformer configured to convert a master voltage of the master device to a sensor voltage of the isolated sensor; and
   isolation barriers configured to transmit signals between the master-side conversion circuit and the sensor-side conversion circuit.
Numbered Clause 17. The system of Numbered Clause 16,
   wherein the isolation barriers comprise:
   a first isolation barrier transmitting signals from the master-side conversion circuit to the sensor-side conversion circuit; and
   a second isolation barrier transmitting signals from the sensor-side conversion circuit to the master-side conversion circuit.
Numbered Clause 18. The system of any of Numbered Clauses 15 to 17,
   wherein the master-side conversion circuit comprises:
   a master analog-to-digital converter configured to convert master analog signals from the master device to master digital signals for transmission through the isolation circuit to the sensor-side conversion circuit, and
   a master digital-to-analog converter configured to convert sensor digital signals received through the isolation circuit from the isolated sensor to sensor analog signals for transmission to the master device; and
   wherein the sensor-side conversion circuit comprises:
      a sensor analog-to-digital converter configured to convert sensor analog signals from the isolated sensor to sensor digital signals for transmission through the isolation circuit to the master-side conversion circuit, and
      a sensor digital-to-analog converter configured to convert master digital signals received through the isolation circuit from the master device to master analog signals for transmission to the isolated sensor.
Numbered Clause 19. The system of any of Numbered Clauses 15 to 18,
   wherein the master device is configured to modulate data on a DC master signal transmitted on a master current line to the master-side conversion circuit, the data comprising a request for the isolated sensor, and
   wherein the isolated sensor is configured to modulate the data on a DC sensor signal transmitted on a sensor current line to the sensor-side conversion circuit, the data comprising a response to the request.
Numbered Clause 20. The system of any of Numbered Clauses 15 to 19,
   wherein the master-side conversion circuit operates at a first voltage level and with reference to the master ground reference,
   wherein the sensor-side conversion circuit operates at a second voltage level and with reference to the sensor ground reference, and
   wherein the circuit electrically isolates the first voltage level and the master ground reference from the second voltage level and the sensor ground reference.

## Claims

1. A circuit for bi-directional communication between a master device and an isolated sensor, comprising:
a master-side conversion circuit operating at a master ground reference of the master device, the master-side conversion circuit configured to convert communications output from and input to the master device;
a sensor-side conversion circuit operating at a sensor ground reference of the isolated sensor, the sensor-side conversion circuit configured to convert communications output from and input to the isolated sensor; and
an isolation circuit positioned between the master-side conversion circuit and the sensor-side conversion circuit, the isolation circuit configured to power the isolated sensor by isolating the master ground reference from the isolated sensor ground reference during power transfer and data transfers between the master device and the isolated sensor.

2. The circuit of claim 1,
wherein the isolation circuit comprises:
a transformer configured to convert a master voltage of the master device to a sensor voltage of the isolated sensor and isolate the master ground reference from the sensor ground reference; and
isolation barriers configured to transmit signals between the master-side conversion circuit and the sensor-side conversion circuit.

3. The circuit of claim 2,
wherein the isolation barriers comprise:
a first isolation barrier for transmitting signals from the master-side conversion circuit to the sensor-side conversion circuit; and
a second isolation barrier for transmitting signals from the sensor-side conversion circuit to the master-side conversion circuit.

4. The circuit of any preceding claim,
wherein the master-side conversion circuit comprises:
a master analog-to-digital converter configured to convert master analog signals from the master device to master digital signals for transmission through the isolation circuit to the sensor-side conversion circuit, and
a master digital-to-analog converter configured to convert sensor digital signals received through the isolation circuit from the isolated sensor to sensor analog signals for transmission to the master device; and
wherein the sensor-side conversion circuit comprises:
a sensor analog-to-digital converter configured to convert sensor analog signals from the isolated sensor to sensor digital signals for transmission through the isolation circuit to the master-side conversion circuit, and
a sensor digital-to-analog converter configured to convert the master digital signals received through the isolation circuit from the master device to the master analog signals for transmission to the isolated sensor.

5. The circuit of any preceding claim,
wherein the master device is configured to modulate data on a DC master signal transmitted on master current line to the master-side conversion circuit, the data comprising a request for the isolated sensor, and
wherein the isolated sensor is configured to modulate the data on a DC sensor signal transmitted on a sensor current line to the sensor-side conversion circuit, the data comprising a response to the request.

6. The circuit of any preceding claim,
wherein the master-side conversion circuit operates at a first voltage level and with reference to the master ground reference,
wherein the sensor-side conversion circuit operates at a second voltage level and with reference to the sensor ground reference, and
wherein the circuit electrically isolates the first voltage level and the master ground reference from the second voltage level and the sensor ground reference.

7. The circuit of claim 6,
wherein the isolation circuit comprises a transformer configured to convert the first voltage level to the second voltage level while maintaining electrical isolation between the master ground reference and the sensor ground reference.

8. A method for bi-directional communication between a master device and an isolated sensor, comprising:
converting, by a master-side conversion circuit operating at a master ground reference of the master device, communications output from and input to the master device;
converting, by a sensor-side conversion circuit operating at a sensor ground reference of the isolated sensor, communications output from and input to the isolated sensor; and
powering the isolated sensor and isolating data transfers between the master device and the isolated sensor using an isolation circuit positioned between the master-side conversion circuit and the sensor-side conversion circuit, wherein powering the isolated sensor comprises converting a master voltage of the master device to a sensor voltage of the isolated sensor and isolating the master ground reference from the sensor ground reference.

9. The method of claim 8, comprising:
converting, by a transformer, the master voltage of the master device to the sensor voltage of the isolated sensor; and
processing, by isolation barriers, signals transmitted between the master-side conversion circuit and the sensor-side conversion circuit to isolate the master ground reference from the sensor ground reference during data transfers.

10. The method of claim 9, comprising:
transmitting signals from the master-side conversion circuit to the sensor-side conversion circuit using a first isolation barrier; and
transmitting signals from the sensor-side conversion circuit to the master-side conversion circuit using a second isolation barrier.

11. The method of any of claims 8 to 10, comprising:
converting communications by the master-side conversion circuit by:
converting master analog signals from the master device to master digital signals for transmission through the isolation circuit to the sensor-side conversion circuit using a master analog-to-digital converter, and
converting sensor digital signals received through the isolation circuit from the isolated sensor to sensor analog signals for transmission to the master device using a master digital-to-analog converter; and
converting communications by the sensor-side conversion circuit by:
converting sensor analog signals from the isolated sensor to sensor digital signals for transmission through the isolation circuit to the master-side conversion circuit using a sensor analog-to-digital converter, and
converting the master digital signals received through the isolation circuit from the master device to the master analog signals for transmission to the isolated sensor using a sensor digital-to-analog converter.

12. The method of any of claim 8 to 11, further comprising:
modulating, by the master device, data on a DC master signal transmitted on a master current line to the master-side conversion circuit, the data comprising a request for the isolated sensor; and
modulating, by the isolated sensor, the data on a DC sensor signal transmitted on a sensor current line to the sensor-side conversion circuit, the data comprising a response to the request.

13. The method of any of claims 8 to 12, comprising:
operating the master-side conversion circuit at a first voltage level and with reference to the master ground reference;
operating the sensor-side conversion circuit at a second voltage level and with reference to the sensor ground reference; and
electrically isolating the first voltage level and the master ground reference from the second voltage level and the sensor ground reference.

14. The method of claim 13, wherein the isolation circuit comprises a transformer, and the method further comprises:
converting, by the transformer of the isolation circuit, the first voltage level to the second voltage level while maintaining electrical isolation between the master ground reference and the sensor ground reference.

15. A system for bi-directional communication, comprising:
a master device;
an isolated sensor; and
a circuit according to any of claims 1 to 7.
